# EUROPEAN PATENT SPECIFICATION

(11) **EP 3 514 440 B1**
(45) Date of publication and mention of the grant of the patent: **29.12.2021**
(21) Application number: 18171641.6
(22) Date of filing: 09.05.2018
(51) Int. Cl.: F21K 9/232, F21Y 103/10, F21Y 115/10

(54) **METHOD OF MANUFACTURING A LED LIGHT BULB HAVING THERMAL RADIATION FILAMENTS**
VERFAHREN ZUR HERSTELLUNG EINER LED-GLÜHBIRNE MIT WÄRMEABSTRAHLENDEN FILAMENTEN
PROCÉDÉ DE FABRICATION D'UNE AMPOULE BULBE À DELS COMPORTANT DES FILAMENTS DE RAYONNEMENT THERMIQUE

(30) Priority: 18.01.2018 US 201815874343
(43) Date of publication of application: 24.07.2019
(73) Proprietor: BGT Materials Limited, Manchester M13 9PL (GB)
(72) Inventor: LAI, CHUNG- PING, 302 HSINCHU COUNTY (TW); CHANG, KUO-HSIN, 622 CHIAYI COUNTY (TW)
(74) Representative: Lang, Christian

(56) References cited:
- EP-A1- 3 208 514
- GB-A- 2 529 445
- US-A1- 2016 309 550
- US-A1- 2017 299 129

## Description

### BACKGROUND OF THE INVENTION

### FIELD OF THE INVENTION

The present invention relates to a method of making a LED light bulb, and more particularly to a method of making a LED light bulb with thermal radiation filaments.

### DESCRIPTION OF THE PRIOR ART

A conventional light bulb is disclosed in US 2014/0211475 A1 and contains: a light-emitting module; a heat-dissipation carrier including a first surface and a second surface opposite to the first surface, disposed under the light-emitting module for conducting heat generated by the light-emitting module away from the light-emitting module; and a heat radiator disposed above the heat-dissipation carrier for radiating heat away from the heat-dissipation carrier, wherein the material of the heat-radiating material coated on the surface of the heat radiator can include carbon-containing compound such as SiC, graphene, metal oxide such as ZnO, or III-nitride compound such as BN. However, as high-power LED bulb is required to generate enough light for illumination purpose rather than direction light, the heat-dissipation design became insufficient so that the heat-dissipation carrier is often enlarged to be bulky metal heat skin, and more effective heat spreading materials are required. The developed thermal management of LED bulb increases the cost of bulbs and the cooling structure is both bulky and heavy that offsets the benefits of LED.

For light bulb application, thermal conductivity only allows heat to be conducted downward to the base. Honestly speaking, this is not efficient because filament will be connected to electronics which generate more heat. Furthermore, the power electronics will be kept in the very tight enclosure like E27/ GU10 connector. The heat dissipation is problematic. Graphene has been well-known for its outstanding heat conductivity, and high surface area. Both properties indicate graphene to be a promising candidate of heat-spreading solution. However, relative designs in recent years show several shortages.

US 2010/0085713 A1 proposed lateral graphene as heat spreaders for electronic device and circuits. The integration process, either growing graphene by CVD process or transferring exfoliated graphene, is high cost and fairly complicated, which is not favorable for commercialization. Graphene film/papers are proposed as heat spreaders such as in US 2013/0329366 A1 and in US 2014/0224466 A1. Graphene films were produced from graphene nanoplatelets. By compression, graphene films were formed. However, the adhesion of films onto heat source or heat sink may create another heat resistance between interfaces, and lower the heat dissipation effect.

US 2017/0299129 A1 describes a method of making a LED light bulb with graphene coated on flexible printed circuit board (PCB) based LED filaments.

EP 3 208 514 A1 describes a LED light bulb using a black body radiation layer of e.g. graphene coated on either rigid or flexible LED filaments.

US 2016/0309550 A1 describes various LED tube lamps.

GB 2 529 445 A describes a method of making a LED light bulb comprising flip chip LEDs bonded to a PCB comprising a copper-graphene laminate layer.

The present invention has arisen to mitigate and/or obviate the afore-described disadvantages.

### SUMMARY OF THE INVENTION

The present invention provides a method of making a LED light bulb with thermal radiation filaments which removes heat away from a heat source rapidly, in accordance with the appended claim 1.

According to the present invention as defined by the appended claims, the method of making a LED light bulb with thermal radiation filaments contains steps of:
A. providing a substrate which includes multiple conductive portions formed on two ends of the substrate respectively so as to electrically connect with an electronic circuit, the substrate being made of any one of metal, ceramic, glass and plastic;
B. molding LED chips, wires, and phosphors on a front face of the substrate so as to produce a LED filament sheet, wherein in step B a sub-step of wire bonding is performed using wires which are serially connected with the LED chips and are electrically connected with the multiple conductive portions of the substrate respectively so as to form a serial circuit;
C. forming a thermal radiation dissipation film on a back face of the substrate before or after producing the LED filament sheet;
D. cutting the substrate into the thermal radiation filaments, wherein each of the thermal radiation filaments has a part of the thermal radiation dissipation film, a part of the LED filament sheet, and parts of the multiple conductive portions respectively; and
E. fixing the thermal radiation filaments into the LED light bulb.

Advantageous, further embodiments of the present invention are the object of the appended dependent claims.

Preferably, step B has a sequence of sub-steps of:
B1. die bonding, wherein the LED chips are die bonded to the front face of the substrate;
B2. wire bonding, wherein the wires are serially connected with the LED chips and are electrically connected with the multiple conductive portions of the substrate respectively so as to form the serial circuit; and
B3. forming the phosphors, wherein a phosphor glue is coated on the LED chips so as to form the phosphors on the LED chips.

Preferably, phosphor glue is coated on the LED chips and the wires so that the phosphors cover the LED chips and the wires, and the phosphors do not cover the multiple conductive portions of the substrate.

Preferably, the thermal radiation dissipation film is formed on the back face of the substrate by coating thermal radiation dissipation ink on the back face of the substrate.

Preferably, the thermal radiation dissipation film is formed on the back face of the substrate by adhering the thermal radiation dissipation film on the back face of the substrate, and the thermal radiation dissipation film has an adhesive layer.

Preferably, the adhesive layer is thermally conductive adhesive or thermal tape.

Preferably, the substrate is made of flexible ceramic or flexible glass.

Preferably, the thermal radiation filaments are fixed into the LED light bulb and are bent at a curvature or in an arc shape.

Preferably, the thermal radiation dissipation film is formed on the back face of the substrate by coating thermal radiation dissipation ink on the back face of the substrate in any one of a spray coating manner, a brushing manner, a screen printing manner, and a nozzle printing manner,

Preferably, the thermal radiation dissipation ink contains dissipation fillers, dispersants, and binders.

Preferably, the dissipation fillers are any one of carbon materials, metal particles, infrared-ray radiation powders, and a mixture of the carbon materials, the metal particles, and the infrared-ray radiation powders.

Preferably, the carbon materials are any one of graphene, carbon black, graphite, carbon nanotubes, activated carbon and a mixture of the graphene, the carbon black, the graphite, the carbon nanotubes, and the activated carbon.

Preferably, the metal particles are any one of copper (Cu), nickel (Ni), zinc (Zn), iron (Fe), cobalt (Co), silver (Ag), gold (Au), platinum (Pt), and a mixture of the Cu, the Ni, the Zn, the Fe, the Co, the Ag, the Au, and the Pt.

Preferably, the infrared-ray radiation powders are made of any one of silica (SiO2), alumina (Al2O3), titanium dioxide (TiO2), zirconia (ZrO2), zirconium carbide (ZrC), silicon Carbide (SiC), tantalum carbide (TaC), titanium diboride (TiB2), zirconium diboride (ZrB2), titanium disilicide (TiSi2), silicon nitride (Si3N4), titanium nitride (TiN), boron nitride (BN), and a mixture of the SiO2, the Al2O3, the TiO2, the ZrO2, the ZrC, the SiC, the TaC, the TiB2, the ZrB2, the TiSi2, the Si3N4, the TiN, and the BN.

### BRIEF DESCRIPTION OF THE DRAWINGS

FIG. 1 shows a thermal radiation dissipation film being coated on a polyethylene terephthalate (PET) substrate, and the measurement tool of thermal conductivity.
FIG. 2 shows a thermal conductivity of the thermal radiation dissipation film, which is in a range from 40 W/mK to 90 W/mK at room temperature.
FIG. 3 is a flow chart showing a method of making a LED light bulb with thermal radiation filaments according to a preferred embodiment of the present invention.
FIG. 4 is a flow chart showing sub-steps of a step of B of the method of the LED bulb with the thermal radiation filaments according to the preferred embodiment of the present invention.
FIG. 5 is a flow chart showing a method of making a LED light bulb with thermal radiation filaments according to another preferred embodiment of the present invention.
FIG. 6-1 shows a substrate, which is printed circuit board (PCB) in the front side according to the preferred embodiment of the present invention.
FIG. 6-2 shows a substrate, which is printed circuit board (PCB) in the back side according to the preferred embodiment of the present invention.
FIGS. 7 to 12 are schematic views showing steps of making the LED light bulb of FIG. 3 according to the preferred embodiment of the present invention.
FIG. 13 is a cross sectional view showing the assembly of a thermal radiation filament according to the preferred embodiment of the present invention.
FIG. 14 is another cross sectional view showing the assembly of the thermal radiation filament according to the preferred embodiment of the present invention.
FIG. 15-1 is a schematic view showing a graphene-based thermal radiation dissipation film being coated on a substrate made of copper according to the preferred embodiment of the present invention.
FIG. 15-2 is a schematic view showing a graphene-based thermal radiation dissipation film being coated on a substrate made of aluminum according to the preferred embodiment of the present invention.
FIG. 15-3 is a schematic view showing a graphene-based thermal radiation dissipation film being coated on substrate made of PET according to the preferred embodiment of the present invention.
FIG. 16 is a schematic view showing the assembly of a thermal radiation filament according to another preferred embodiment of the present invention.
FIG. 17 is a schematic view showing temperatures of the thermal radiation filaments of the present invention reduce 25°C less than conventional LED filaments after a period of using time.

### DETAILED DESCRIPTION OF THE PREFERRED EMBODIMENTS

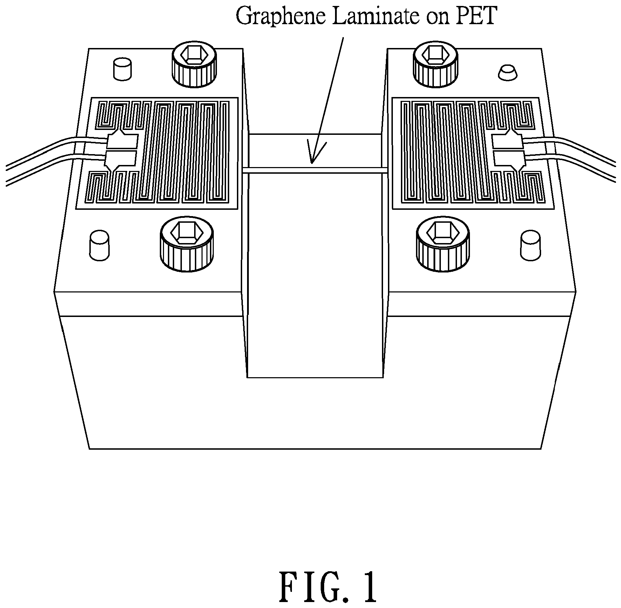

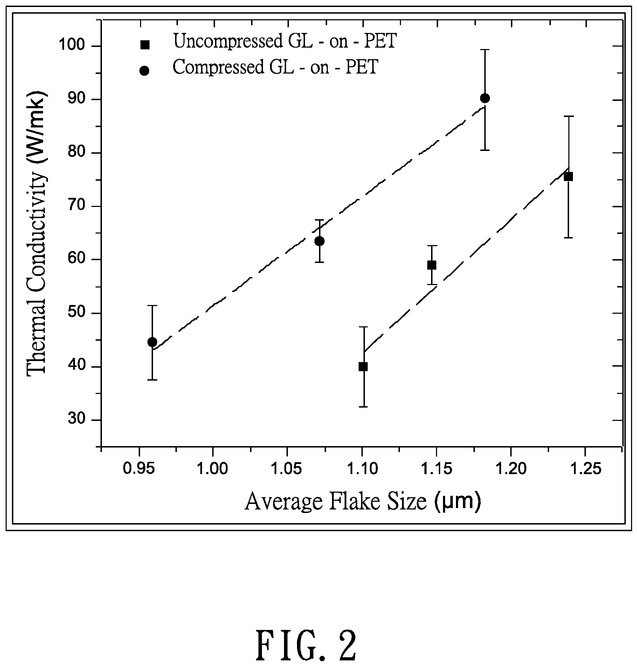

With reference to FIGS. 1 to 2, a graphene laminate film is deposited on a polyethylene terephthalate (PET) substrate, and a thermal conductivity of the graphene laminate film is within 40 W/mK to 90 W/mK at a room temperature so as to provide up to 600 × higher thermal conductivity than plastics. Thus, a LED light bulb with thermal radiation filaments made by a method of a preferred embodiment of the present invention removes heat away from a heat source rapidly.

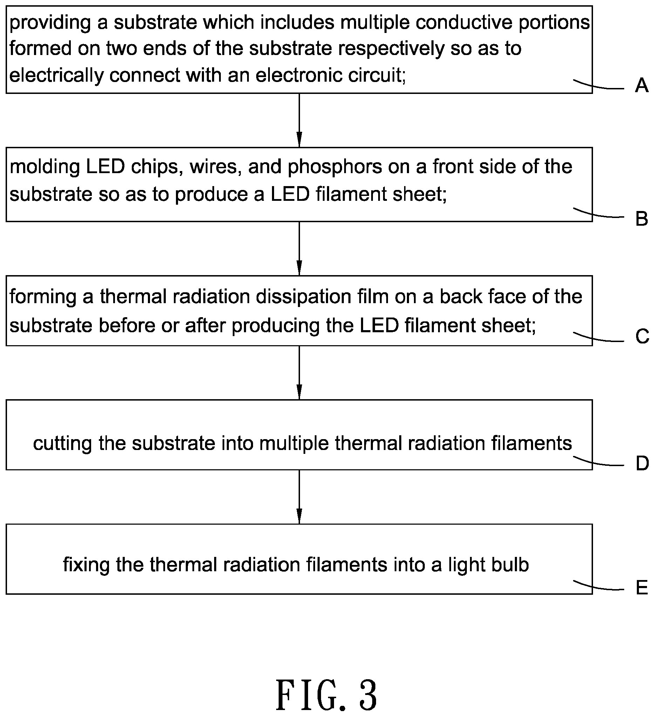

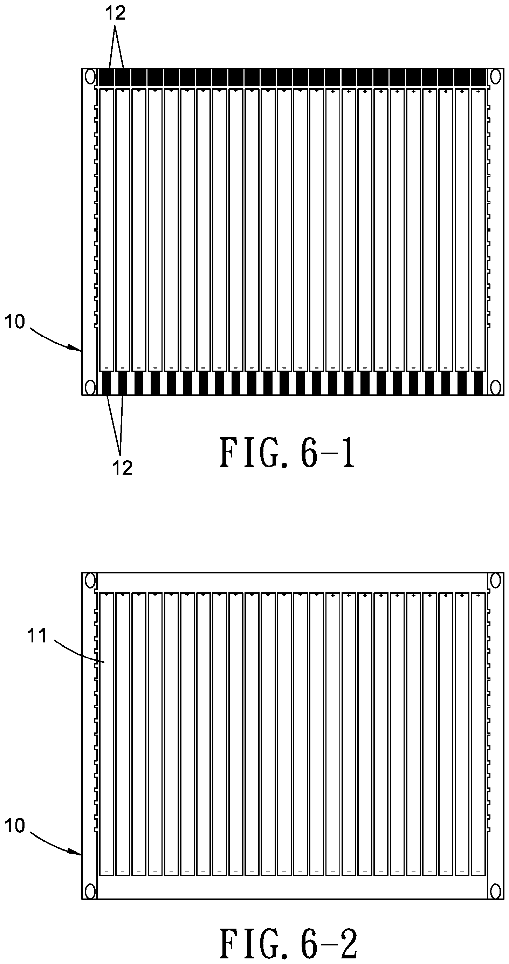

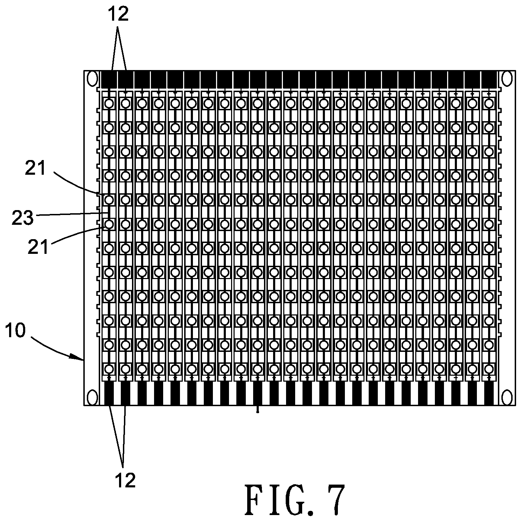

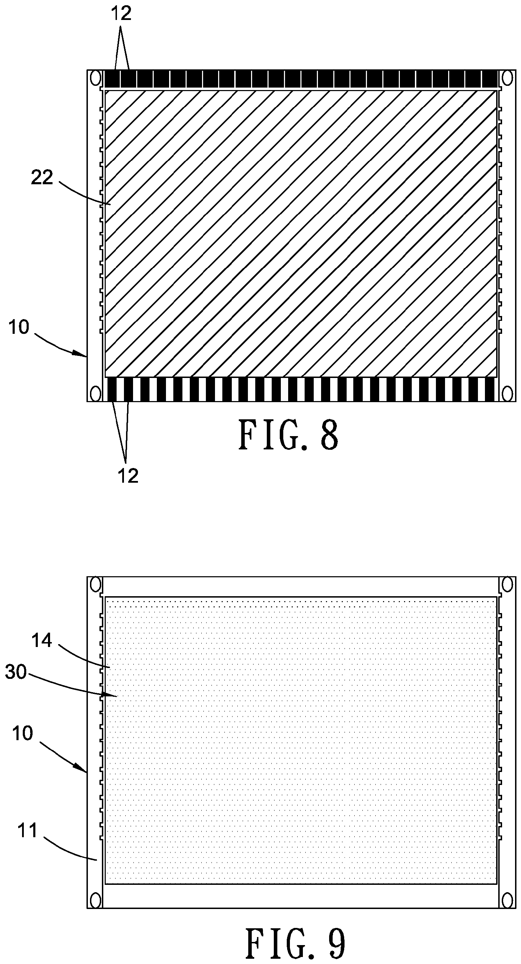

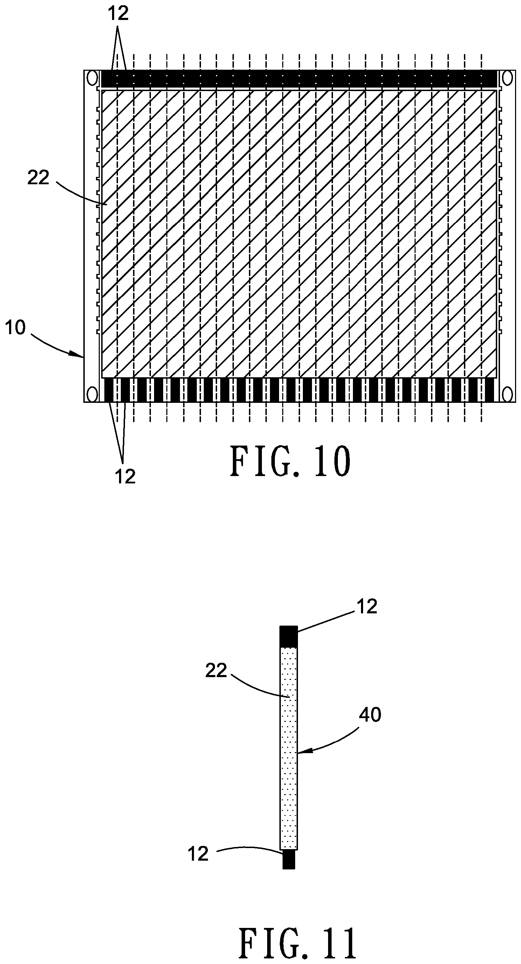

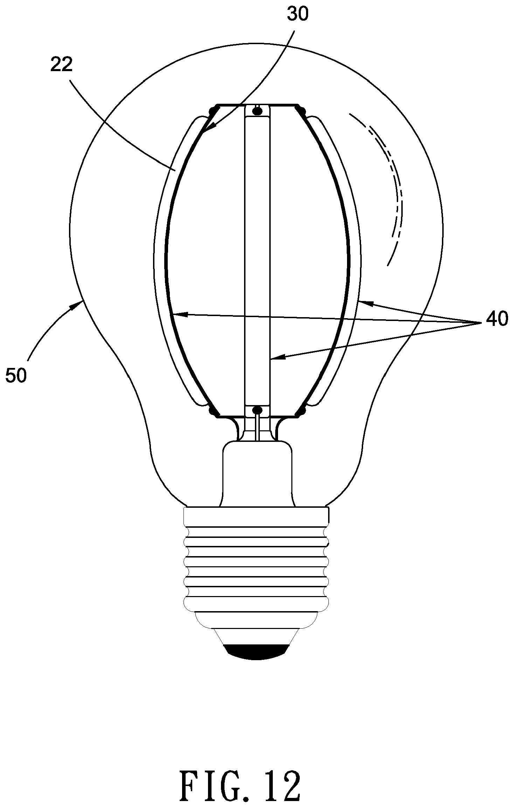

Referring to FIGS. 3, 6-1, 6-2, 7 to 12, a method of making the LED light bulb with the thermal radiation filaments according to the preferred embodiment of the present invention comprising the steps of:
A. providing a substrate 10 which includes multiple conductive portions 12 formed on two ends of the substrate 10 respectively so as to electrically connect with an electronic circuit (as shown in FIG. 6-1), wherein the substrate 10 is made any one of metal, ceramic, glass, and plastic;
B. molding LED chips 21, wires 23, and phosphors 22 on a front face of the substrate 10 so as to produce a LED filament sheet 20 (as shown in FIG. 7 and FIG. 8);
C. forming the thermal radiation dissipation film 30 on a back face 11 of the substrate 10 (as illustrated in FIG. 9) before or after producing the LED filament sheet 20;
D. cutting the substrate 10 (as shown in FIG. 10) into the thermal radiation filaments 40 (as illustrated in FIG. 11), wherein each of the thermal radiation filaments 40 has a part of the thermal radiation dissipation film 30 on a part of the back face 11, a part of the LED filament sheet 20 on a part of the front face of the substrate 10, and parts of the multiple conductive portions 12 on parts of the two ends of the substrate 10 respectively; and
E. fixing the thermal radiation filaments 40 into the LED light bulb 50 (as shown in FIG. 12).

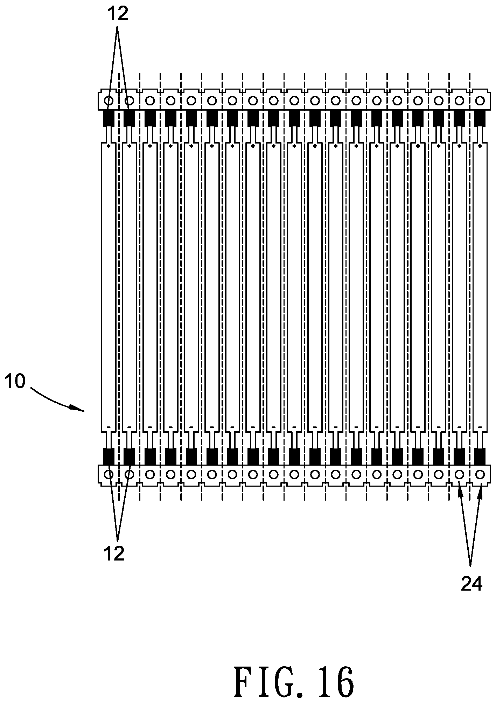

Referring to FIG. 16, in another preferred embodiment, the LED filament sheet 20 includes multiple bases 24 connected together, wherein each of the multiple bases 24 has a LED chip 21, a wire 23, and phosphors 22 on a front face of each base 24, and the base 24 is cut into thermal radiation filaments 40.

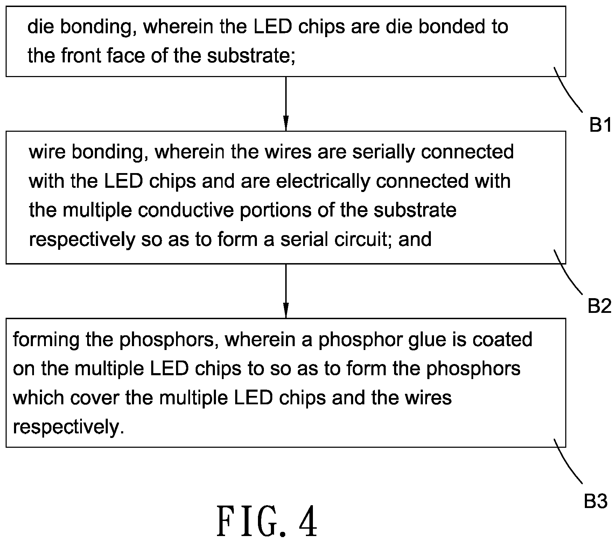

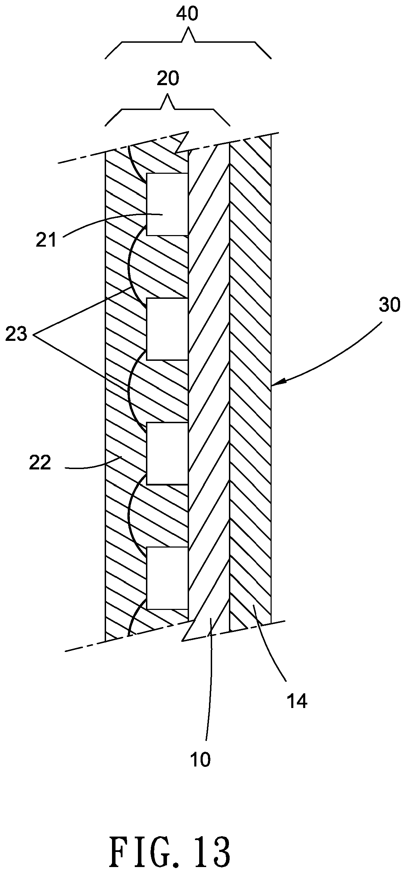

With reference to FIG. 4, the step B has sub-steps of:
B1. die bonding, wherein the LED chips 21 are die bonded to the front face of the substrate 10;
B2. wire bonding, wherein the wires 23 are serially connected with the LED chips 21 and are electrically connected with the multiple conductive portions 12 of the substrate 10 respectively so as to form a serial circuit; and
B3. forming the phosphors 22, wherein phosphor glue is coated on the LED chips 21 so as to form the phosphors 22 on the LED chips 21. In another embodiment, the phosphor glue is coated on the LED chips 21 and the wires 23 so that the phosphors 22 cover the LED chips 21 and the wires 23, as illustrated in FIG. 13, and the phosphors 22 do not cover the multiple conductive portions 12 of the substrate 10.

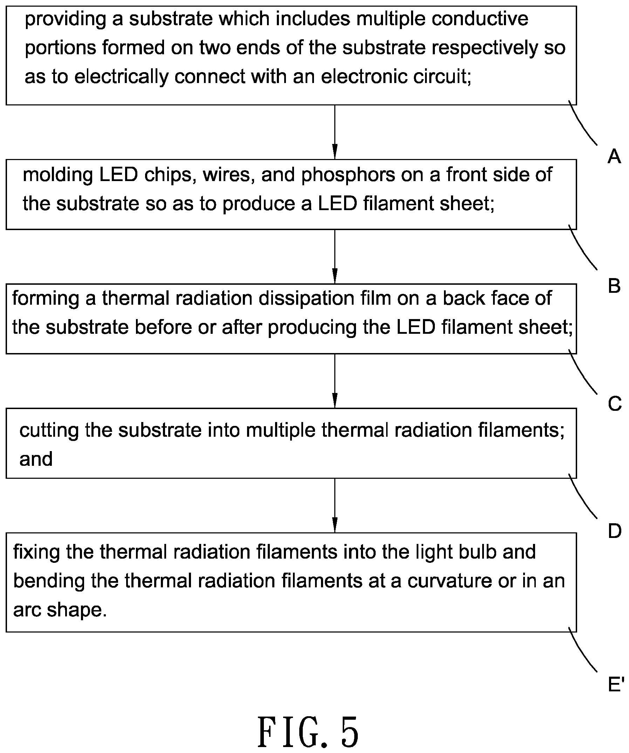

With reference to FIG. 5, a method of making a LED light bulb with thermal radiation filaments according to another preferred embodiment of the present invention comprising the steps of:
A. providing a substrate 10 which includes multiple conductive portions 12 formed on two ends of the substrate 10 respectively so as to electrically connect with an electronic circuit, wherein the substrate 10 is made any one of metal, ceramic, glass, and plastic;
B. molding LED chips 21, wires 23, and phosphors 22 on a front face of the substrate 10 so as to produce a LED filament sheet 20 (as shown in FIG. 7 and FIG. 8);
C. forming the thermal radiation dissipation film 30 on a back face 11 of the substrate 10 (as illustrated in FIG. 9) before or after producing the LED filament sheet 20;
D. cutting the substrate 10 (as shown in FIG. 10) into the thermal radiation filaments 40 (as illustrated in FIG. 11), wherein each of the thermal radiation filaments 40 has a part of the thermal radiation dissipation film 30 on a part of the back face 11, a part of the LED filament sheet 20 on a part of the front face of the substrate 10, and parts of the multiple conductive portions 12 on parts of two ends of the substrate 10 respectively; and
E'. fixing the thermal radiation filaments 40 into the LED light bulb 50 and bending the thermal radiation filaments 40 at a curvature or in an arc shape.

In accordance with the present invention, the substrate 10 is made of any one of metal, ceramic, glass and plastic. Preferably, the substrate 10 is made of any one of flexible ceramic and flexible glass. Thereby, the thermal radiation filaments 40 are curvedly fixed into the LED light bulb 50 based on a shape of the LED light bulb 50.

The thermal radiation dissipation film 30 is formed on the back face 11 of the substrate 10 by coating thermal radiation dissipation ink 14 on the back face 11 of the substrate 10 in any one of a spray coating manner, a brushing manner, a screen printing manner, and a nozzle printing manner, and the thermal radiation dissipation ink 14 is dried so as to form the thermal radiation dissipation film 30.

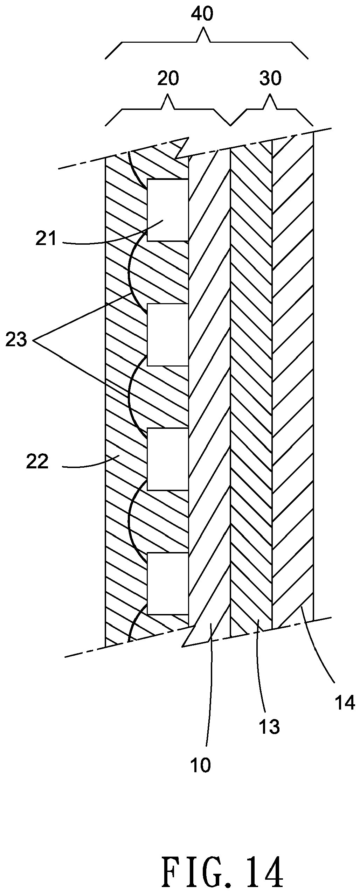

In another embodiment, the thermal radiation dissipation film 30 is formed on the back face 11 of the substrate 10 by adhering the thermal radiation dissipation film 30 on the back face 11 of the substrate 10, wherein the thermal radiation dissipation film 30 has an adhesive layer 13, as shown in FIG. 14, and the adhesive layer 13 is thermally conductive adhesive or thermal tape.

The thermal radiation dissipation ink 14 contains dissipation fillers, dispersants, and binders, wherein the dissipation fillers are any one of carbon materials, metal particles, infrared-ray radiation powders, and a mixture of the carbon materials, the metal particles, and the infrared-ray radiation powders.

The carbon materials are any one of graphene, carbon black, graphite, carbon nanotubes, activated carbon and a mixture of the graphene, the carbon black, the graphite, the carbon nanotubes, and the activated carbon.

The metal particles are any one of copper (Cu), nickel (Ni), zinc (Zn), iron (Fe), cobalt (Co), silver (Ag), gold (Au), platinum (Pt), and a mixture of the Cu, the Ni, the Zn, the Fe, the Co, the Ag, the Au, and the Pt.

The infrared-ray radiation powders are made of any one of silica (SiO2), alumina (Al2O3), titanium dioxide (TiO2), zirconia (ZrO2), zirconium carbide (ZrC), silicon carbide (SiC), tantalum carbide (TaC), titanium diboride (TiB2), zirconium diboride (ZrB2), titanium disilicide (TiSi2), silicon nitride (Si3N4), titanium nitride (TiN), boron nitride (BN), and a mixture of the SiO2, the Al2O3, the TiO2, the ZrO2, the ZrC, the SiC, the TaC, the TiB2, the ZrB2, the TiSi2, the Si3N4, the TiN, and the BN.

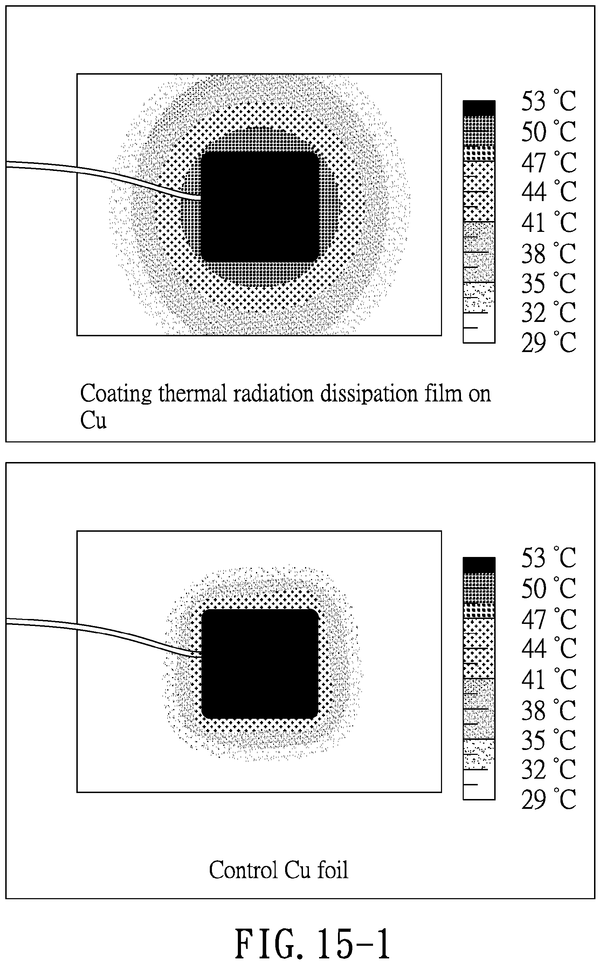

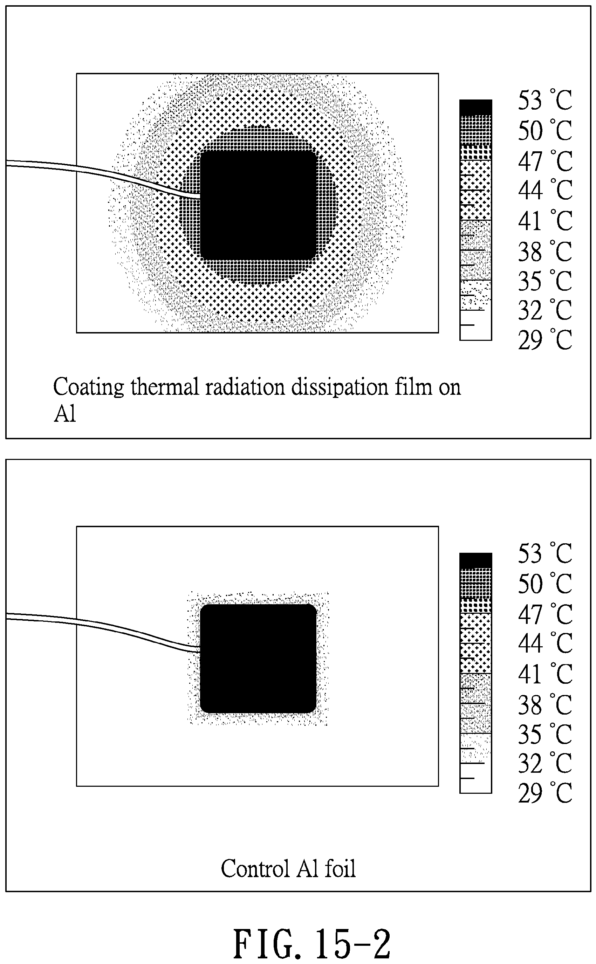

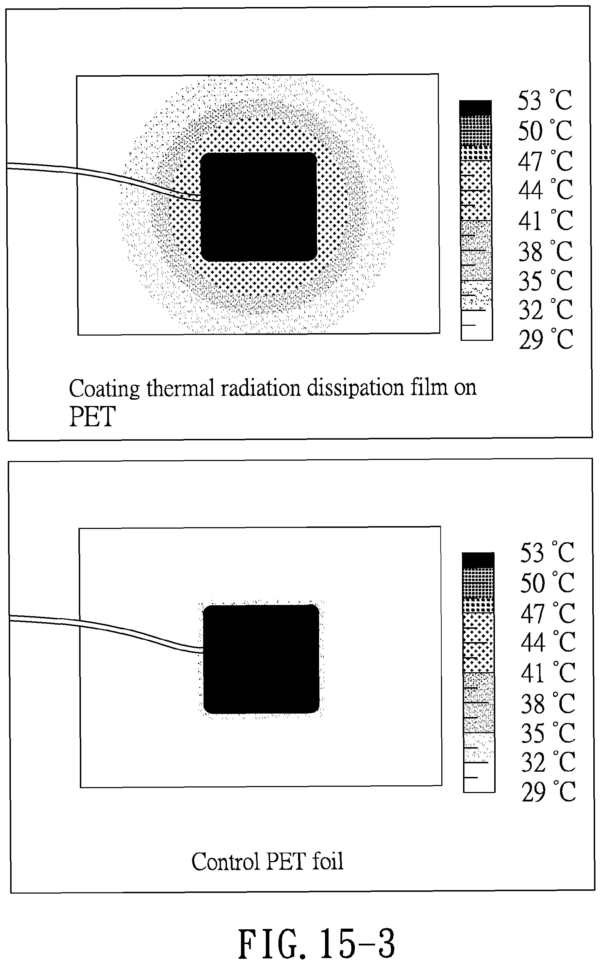

The carbon materials are made of graphene so that the thermal radiation dissipation ink 14 forms a graphene-based thermal radiation dissipation film, thus obtaining brilliant heat dissipation. For example, the graphene-based thermal radiation dissipation film is coated on substrates (as shown in FIGS. 15-1 to 15-3) and temperatures of the substrates 10 are measured respectively, wherein the substrates 10 are made of copper as shown in FIG. 15-1; the substrates 10 are made of aluminum as illustrated in FIG. 15-2; and the substrates 10 are made of PET as shown in FIG. 15-3.

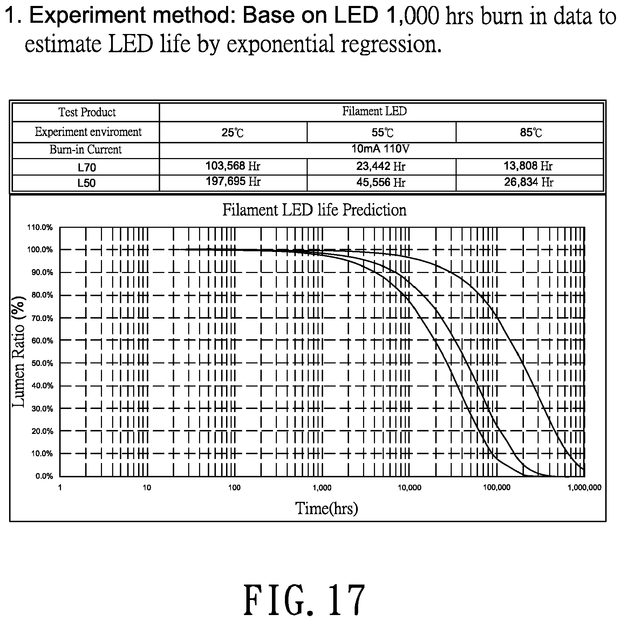

With reference to FIG. 17, temperatures of the thermal radiation filaments 40 of the present invention reduce 25°C less than conventional LED filaments after a period of using time. Preferably, the thermal radiation filaments 40 prolong a service life of the LED light bulb 50 effectively.

While the preferred embodiments of the invention have been set forth for the purpose of disclosure, modifications of the disclosed embodiments of the invention as well as other embodiments thereof may occur to skilled in the art.

The scope of the invention is defined by the following claims.

## Claims

1. A method of making a LED light bulb (50) with thermal radiation filaments (40) comprising steps of:
A. providing a substrate (10) which includes multiple conductive portions (12) formed on two ends of the substrate (10) respectively so as to electrically connect with an electronic circuit;
B. molding LED chips (21) and phosphors (22) on a front face of the substrate (10) so as to produce a LED filament sheet (20);
C. forming a thermal radiation dissipation film (30) on a back face (11) of the substrate (10) before or after producing the LED filament sheet (20);
D. cutting the substrate (10) into the thermal radiation filaments (40), wherein each of the thermal radiation filaments (40) has a part of the thermal radiation dissipation film (30), a part of the LED filament sheet (20), and parts of the multiple conductive portions (12) respectively; and
E. fixing the thermal radiation filaments (40) into the LED light bulb (50);
**characterized in that**
the substrate (10) provided in step A is made of any one of metal, ceramic, glass and plastic; and
in step B, a sub-step of wire bonding is performed using wires (23), wherein the wires (23) are serially connected with the LED chips (21) and are electrically connected with the multiple conductive portions (12) of the substrate (10) respectively so as to form a serial circuit.

2. The method as claimed in claim 1, wherein step B sequentially comprises the sub-steps of:
B1. die bonding, wherein the LED chips (21) are die bonded to the front face of the substrate (10);
B2. wire bonding, wherein the wires (23) are serially connected with the LED chips (21) and are electrically connected with the multiple conductive portions (12) of the substrate (10) respectively so as to form the serial circuit; and
B3. forming the phosphors (22), wherein phosphor glue is coated on the LED chips (21) so as to form the phosphors (22) on the LED chips (21).

3. The method as claimed in claim 1, wherein phosphor glue is coated on the LED chips (21) and the wires (23) so that the phosphors (22) cover the LED chips (21) and the wires (23), and the phosphors (22) do not cover the multiple conductive portions (12) of the substrate (10).

4. The method as claimed in claim 1, wherein the thermal radiation dissipation film (30) is formed on the back face (11) of the substrate (10) by coating thermal radiation dissipation ink (14) on the back face (11) of the substrate (10).

5. The method as claimed in claim 1, wherein the thermal radiation dissipation film (30) is formed on the back face (11) of the substrate (10) by adhering the thermal radiation dissipation film (30) on the back face (11) of the substrate (10), and the thermal radiation dissipation film (30) has an adhesive layer (13).

6. The method as claimed in claim 5, wherein the adhesive layer (13) is thermally conductive adhesive or thermal tape.

7. The method as claimed in claim 1, wherein the substrate (10) is made of any one of flexible ceramic and flexible glass.

8. The method as claimed in claim 1 or in claim 7, wherein the thermal radiation filaments (40) are fixed into the LED light bulb (50) and are bent at a curvature or in an arc shape.

9. The method as claimed in claim 1, wherein the thermal radiation dissipation film (30) is formed on the back face (11) of the substrate (10) by coating thermal radiation dissipation ink (14) on the back face (11) of the substrate (10) in any one of a spray coating manner, a brushing manner, a screen printing manner, and a nozzle printing manner,

10. The method as claimed in any one of claims 4 and 9, wherein the thermal radiation dissipation ink (14) contains dissipation fillers, dispersants, and binders.

11. The method as claimed in claim 10, wherein the dissipation fillers are any one of carbon materials, metal particles, infrared-ray radiation powders, and a mixture of the carbon materials, the metal particles, and the infrared-ray radiation powders.

12. The method as claimed in claim 11, wherein the carbon materials are any one of graphene, carbon black, graphite, carbon nanotubes, activated carbon and a mixture of the graphene, the carbon black, the graphite, the carbon nanotubes, and the activated carbon.

13. The method as claimed in claim 11, wherein the metal particles are any one of copper (Cu), nickel (Ni), zinc (Zn), iron (Fe), cobalt (Co), silver (Ag), gold (Au), platinum (Pt), and a mixture of the Cu, the Ni, the Zn, the Fe, the Co, the Ag, the Au, and the Pt.

14. The method as claimed in claim 11, wherein the infrared-ray radiation powders are made of any one of silica (SiO2), alumina (Al2O3), titanium dioxide (TiO2), zirconia (ZrO2), zirconium carbide (ZrC), silicon Carbide (SiC), tantalum carbide (TaC), titanium diboride (TiB2), zirconium diboride (ZrB2), titanium disilicide (TiSi2), silicon nitride (Si3N4), titanium nitride (TiN), boron nitride (BN), and a mixture of the SiO2, the Al2O3, the TiO2, the ZrO2, the ZrC, the SiC, the TaC, the TiB2, the ZrB2, the TiSi2, the Si3N4, the TiN, and the BN.

## Patentansprüche

1. Verfahren zur Herstellung einer LED - Glühbirne (50) mit Wärmestrahlungs - Filamenten (40), das die folgenden Schritte umfasst:
A. Bereitstellen eines Substrats (10), welches mehrere leitende Abschnitte (12) aufweist, die entsprechend an zwei Enden des Substrats (10) ausgebildet sind, um eine elektrische Verbindung mit einer elektronischen Schaltung herzustellen,
B. Formen von LED - Chips (21) und Leuchtstoffen (22) auf einer Vorderseite des Substrats (10), um eine LED - Filamentfolie (20) herzustellen,
C. Bilden einer Wärmestrahlungs - Zerstreuungsfolie (30) auf einer Rückseite (11) des Substrats (10) vor oder nach der Herstellung der LED - Filamentfolie (20),
D. Schneiden des Substrats (10) in die Wärmestrahlungs - Filamente (40), wobei jedes der Wärmestrahlungs - Filamente (40) jeweils einen Teil der Wärmestrahlungs - Zerstreuungsfolie (30), einen Teil der LED - Filamentfolie (20) und Teile der mehrfachen leitenden Abschnitte (12) aufweist, und
E. Befestigen der Wärmestrahlungs - Filamente (40) in der LED - Glühbirne (50),
**dadurch gekennzeichnet, dass**
das in Schritt A bereitgestellte Substrat (10) aus einem beliebigen Metall, Keramik, Glas oder Kunststoff besteht und
in Schritt B, ein Teilschritt des Drahtbondens unter Verwendung von Drähten (23) durchgeführt wird, wobei die Drähte (23) mit den LED - Chips (21) in Reihe geschaltet sind und jeweils mit den mehreren leitenden Abschnitten (12) des Substrats (10) elektrisch verbunden sind, um eine Reihenschaltung zu bilden.

2. Verfahren nach Anspruch 1, bei welchem Schritt B nacheinander die folgenden Unterschritte umfasst:
B1. Die-Bonden, wobei die LED-Chips (21) auf die Vorderseite des Substrats (10) gebondet werden,
B2. Drahtbonden, wobei die Drähte (23) mit den LED-Chips (21) in Reihe geschaltet werden und jeweils mit den mehreren leitenden Abschnitten (12) des Substrats (10) elektrisch verbunden werden, um die Reihenschaltung zu bilden,
und
B3. Bilden der Leuchtstoffe (22), wobei Leuchtstoffkleber auf die LED - Chips (21) aufgetragen wird, um die Leuchtstoffe (22) auf den LED - Chips (21) zu bilden.

3. Verfahren nach Anspruch 1, bei welchem Phosphorkleber auf die LED - Chips (21) und die Drähte (23) aufgetragen wird, so dass die Leuchtstoffe (22) die LED - Chips (21) und die Drähte (23) bedecken, und die Leuchtstoffe (22) nicht die mehreren leitenden Abschnitte (12) des Substrats (10) bedecken.

4. Verfahren nach Anspruch 1, bei welchem die Wärmestrahlungs - Zerstreuungsfolie (30) auf die Rückseite (11) des Substrats (10) aufgebracht wird, indem Wärmezerstreuungstinte (14) auf die Rückseite (11) des Substrats (10) aufgetragen wird.

5. Verfahren nach Anspruch 1, bei welchem die Wärmestrahlungs - Zerstreuungsfolie (30) auf der Rückseite (11) des Substrats (10) gebildet wird, indem die Wärmestrahlungs - Zerstreuungsfolie (30) auf die Rückseite (11) des Substrats (10) geklebt wird, und die Wärmestrahlungs - Zerstreuungsfolie (30) eine Klebstoffschicht (13) aufweist.

6. Verfahren nach Anspruch 5, bei welchem die Klebstoffschicht (13) ein wärmeleitender Klebstoff oder ein Wärmeleitband ist.

7. Verfahren nach Anspruch 1, bei welchem das Substrat (10) aus einer flexiblen Keramik oder einem flexiblen Glas hergestellt ist.

8. Verfahren nach Anspruch 1 oder Anspruch 7, bei welchem die Wärmestrahlungs - Filamente (40) in der LED - Glühbirne (50) befestigt und gekrümmt oder bogenförmig gebogen sind.

9. Verfahren nach Anspruch 1, bei welchem die Wärmestrahlungs - Zerstreuungsfolie (30) auf der Rückseite (11) des Substrats (10) durch Auftragen von Wärmezerstreuungstinte (14) auf die Rückseite (11) des Substrats (10) in einer Sprühbeschichtungsmethode, einer Bürstenmethode, einer Siebdruckmethode oder einer Düsendruckmethode gebildet wird.

10. Verfahren nach einem der Ansprüche 4 und 9, bei welchem die Wärmezerstreungstinte (14) Dissipationsfüllstoffe, Dispersionsmittel und Bindemittel enthält.

11. Verfahren nach Anspruch 10, bei welchem es sich bei den Dissipationsfüllstoffen um eines der folgenden Materialien handelt: Kohlenstoffmaterialien, Metallpartikel, Infrarot-Strahlungspulver und eine Mischung aus den Kohlenstoffmaterialien, den Metallpartikeln und den Infrarot-Strahlungspulvern.

12. Verfahren nach Anspruch 11, bei welchem es sich bei den Kohlenstoffmaterialien um Graphen, Ruß, Graphit, Kohlenstoff - Nanoröhren, Aktivkohle und ein Gemisch aus Graphen, Ruß, Graphit, Kohlenstoff-Nanoröhren und Aktivkohle handelt.

13. Verfahren nach Anspruch 11, bei welchem es sich bei den Metallteilchen um eines der folgenden handelt: Kupfer (Cu), Nickel (Ni), Zink (Zn), Eisen (Fe), Kobalt (Co), Silber (Ag), Gold (Au), Platin (Pt) und ein Gemisch aus Cu, Ni, Zn, Fe, Co, Ag, Au und Pt.

14. Verfahren nach Anspruch 11, bei welchem das Infrarot-Strahlungspulver aus einem der folgenden Stoffe bestehen: Siliziumdioxid (SiO2), Aluminiumoxid (Al2O3) Titandioxid (TiO2), Zirkoniumdioxid (ZrO2) Zirkoniumkarbid (ZrC), Siliziumkarbid (Sic), Tantalkarbid (TaC), Titandiborid (TiB2), Zirkoniumdiborid (ZrB2), Titandisilicid (TiSi2), Siliziumnitrid (Si3N4), Titannitrid (TiN), Bornitrid (BN) und einer Mischung aus SiO2, Al2O3, TiO2, ZrO2 ZrC, SiC, TaC, TiB2, ZrB2, TiSi2, Si3N4, TiN und BN.

## Revendications

1. Procédé de fabrication d'une ampoule DEL (50) avec des filaments de rayonnement thermique (40) comprenant les étapes consistant à:
A. fournir un substrat (10) qui inclut de multiples parties conductrices (12) formées sur deux extrémités du substrat (10) respectivement de manière à se connecter électriquement à un circuit électronique;
B. mouler des puces DEL (21) et des phosphores (22) sur une face avant du substrat (10) de manière à produire une feuille de filaments de DEL (20);
C. former un film de dissipation de rayonnement thermique (30) sur une face arrière (11) du substrat (10) avant ou après une production de la feuille de filaments de DEL (20);
D. découper le substrat (10) en les filaments de rayonnement thermique (40), dans lequel chacun des filaments de rayonnement thermique (40) présente une partie du film de dissipation de rayonnement thermique (30), une partie de la feuille de filaments de DEL (20), et des parties des multiples parties conductrices (12), respectivement; et
E. fixer les filaments de rayonnement thermique (40) dans l'ampoule DEL (50); **caractérisé en ce que**
le substrat (10) fourni à l'étape A est réalisé en un quelconque parmi du métal, de la céramique, du verre et du plastique; et
dans l'étape B, une sous-étape de connexion de fils est effectuée à l'aide de fils (23), dans lequel les fils (23) sont connectés en série avec les puces DEL (21) et sont connectés électriquement avec les multiples parties conductrices (12) du substrat (10), respectivement, de manière à former un circuit série.

2. Procédé selon la revendication 1, dans lequel l'étape B comprend séquentiellement les sous-étapes de:
B1. connexion de puce, dans lequel les puces DEL (21) sont connectées par puce à la face avant du substrat (10);
B2. connexion de fils, dans lequel les fils (23) sont connectés en série avec les puces DEL (21) et sont connectés électriquement avec les multiples parties conductrices (12) du substrat (10) respectivement de manière à former le circuit série; et
B3. former les phosphores (22), dans lequel une colle de phosphore est appliquée en revêtement sur les puces DEL (21) de manière à former les phosphores (22) sur les puces DEL (21).

3. Procédé selon la revendication 1, dans lequel la colle de phosphore est appliquée en revêtement sur les puces DEL (21) et les fils (23) de sorte que les phosphores (22) recouvrent les puces DEL (21) et les fils (23), et les phosphores (22) ne recouvrent pas les multiples parties conductrices (12) du substrat (10).

4. Procédé selon la revendication 1, dans lequel le film de dissipation de rayonnement thermique (30) est formé sur la face arrière (11) du substrat (10) par application en revêtement d'une encre de dissipation de rayonnement thermique (14) sur la face arrière (11) du substrat (10).

5. Procédé selon la revendication 1, dans lequel le film de dissipation de rayonnement thermique (30) est formé sur la face arrière (11) du substrat (10) en mettant en adhérence le film de dissipation de rayonnement thermique (30) sur la face arrière (11) du substrat (10), et le film de dissipation de rayonnement thermique (30) présente une couche adhésive (13).

6. Procédé selon la revendication 5, dans lequel la couche adhésive (13) est un adhésif thermiquement conducteur ou un ruban thermique.

7. Procédé selon la revendication 1, dans lequel le substrat (10) est réalisé en un quelconque de la céramique flexible et du verre flexible.

8. Procédé selon la revendication 1 ou la revendication 7, dans lequel les filaments de rayonnement thermique (40) sont fixés dans l'ampoule DEL (50) et sont courbés selon une courbure ou en forme d'arc.

9. Procédé selon la revendication 1, dans lequel le film de dissipation de rayonnement thermique (30) est formé sur la face arrière (11) du substrat (10) en appliquant en revêtement une encre de dissipation de rayonnement thermique (14) sur la face arrière (11) du substrat (10) d'un quelconque parmi une application en revêtement par pulvérisation, un brossage, une sérigraphie et une impression par buse.

10. Procédé selon l'une quelconque des revendications 4 et 9, dans lequel l'encre de dissipation de rayonnement thermique (14) contient des charges de dissipation, des dispersants et des liants.

11. Procédé selon la revendication 10, dans lequel les charges de dissipation sont un quelconque parmi des matériaux carbonés, des particules métalliques, des poudres de rayonnement infrarouge et un mélange des matériaux carbonés, des particules métalliques et des poudres de rayonnement infrarouge.

12. Procédé selon la revendication 11, dans lequel les matériaux carbonés sont un quelconque parmi du graphène, du noir de carbone, du graphite, des nanotubes de carbone, du charbon actif et un mélange du graphène, du noir de carbone, du graphite, des nanotubes de carbone et du charbon actif.

13. Procédé selon la revendication 11, dans lequel les particules métalliques sont un quelconque parmi le cuivre (Cu), le nickel (Ni), le zinc (Zn), le fer (Fe), le cobalt (Co), l'argent (Ag), l'or (Au), le platine (Pt), et un mélange du Cu, du Ni, du Zn, du Fe, du Co, de l'Ag, de l'Au et du Pt.

14. Procédé selon la revendication 11, dans lequel les poudres de rayonnement infrarouge sont constituées de l'un quelconque parmi la silice (SiO₂), l'alumine (Al₂O₃), le dioxyde de titane (TiO₂), la zircone (ZrO₂) le carbure de zirconium (ZrC), le carbure de silicium (SiC), le carbure de tantale (TaC), le diborure de titane (TiB₂), le diborure de zirconium (ZrB₂), le disiliciure de titane (TiSi₂), le nitrure de silicium (Si₃N₄), le nitrure de titane (TiN), le nitrure de bore (BN), et un mélange du SiO₂, du Al₂O₃, du TiO₂, du ZrO₂, du ZrC, du SiC, du TaC, du TiB₂, du ZrB₂, du TiSi₂, du Si₃N₄, du TiN et du BN.
